# EUROPÄISCHE PATENTSCHRIFT

(11) **EP 1 850 481 B1**
(45) Veröffentlichungstag und Bekanntmachung des Hinweises auf die Patenterteilung: **02.09.2009**
(21) Anmeldenummer: 07015897.7
(22) Anmeldetag: 18.07.2003
(51) Int. Cl.: H03K 17/94, H03K 17/96, H05B 33/08, H05B 37/02

(54) **Leuchtmittel mit mehreren LEDs und einem sensitiven Schalter**
Illumination device comprising multiple LEDs and a sensitive switch
Système lumineux comportant plusieurs LEDs et un commutateur sensible

(30) Priorität: 20.07.2002 DE 10233139
(43) Veröffentlichungstag der Anmeldung: 31.10.2007
(62) Teilanmeldung aus: 03016315.8
(73) Patentinhaber: Münchner Hybrid Systemtechnik GmbH, 80339 München (DE)
(72) Erfinder: Strunkeit, Claudia, 86926 Greifenberg (DE); Rudrich, Hans-Peter, 86926 Greifenberg (DE)
(74) Vertreter: Liesegang, Eva

(56) Entgegenhaltungen:
- WO-A-87/02846

## Beschreibung

Die Erfindung betrifft ein Leuchtmittel mit einem sensitiven Schalter, der nach dem Reflexlichttasterprinzip arbeitet und aus einem Strahler in einem lichtdurchlässigen Gehäuse und einem fotosensitiven Element, das im reflektierten Strahlengang des Strahlers angeordnet ist, besteht und in unmittelbarer Nähe des Leuchtmittels angeordnet ist.

Betätigungselemente für Schalter basieren herkömmlich auf mechanischen Bedienelementen. Solche mechanischen Bedienelemente haben einen vergleichsweise großen Platzbedarf und sind anfällig gegenüber ungünstigen Umwelteinflüssen, wie Feuchtigkeit durch beispielsweise Kondensation und tiefe Temperaturen. Neben mechanischen Bedienelementen für Schalter kommen wegen ihres einfachen Fertigungs- und Montageaufwandes und den steigenden Anforderungen an die Zuverlässigkeit und den Komfort der Bedienbarkeit bei unterschiedlichen Umgebungsbedingungen immer häufiger Berührungsschalter auf der Basis von kapazitiven oder optoelektronischen Sensoren zur Anwendung. Das kapazitive Schaltprinzip basiert auf für den Schaltvorgang notwendigen Potentialunterschieden in der Umgebung des Schaltgeräts, welche nicht immer vorhanden sind. Bei den Bedienelementen auf optoelektronischer Basis wird zwischen passiven und aktiven Sensoren unterschieden. In passiven Sensoren kommt nur ein Fotoempfänger oder ein gegenüber Temperaturstrahlung sensitives Element zum Einsatz, während aktive Sensoren einen Strahler und einen fotosensitiven Empfänger aufweisen, wobei der Strahler einen gerichteten Strahl aussendet und der Empfänger die reflektierte Strahlung erfaßt. Hieraus ergibt sich die Möglichkeit, Näherungssensoren zu schaffen, die berührungslos und kontaktlos arbeiten. Solche optoelektronischen Sensoren, die auch als Reflexlichttaster bezeichnet werden, sind z.B. in den Druckschriften DE 42 07 772 A1 und DE 195 47 301 C1 beschrieben und weisen im Vergleich zu passiven Sensoren eine erhöhte Signalsicherheit bei einem geringen Energiebedarf auf.

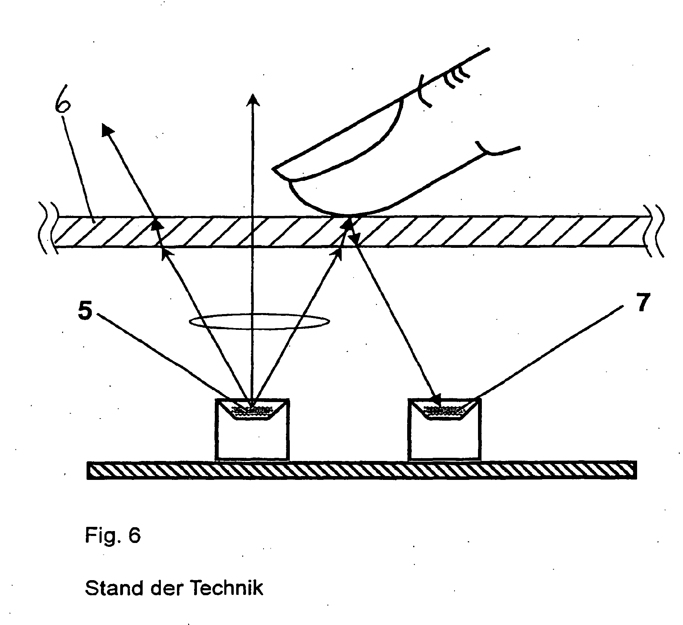

Ein Beispiel eines optoelektronischen Schalters, der als Reflexlichttaster arbeitet, ist auch in Fig. 6 gezeigt. Der Reflexlichttaster weist einen Strahler 5 auf, der einen Lichtstrahl abgibt, sowie ein fotosensitives Element 7 als Empfänger, welches den reflektierten Lichtstrahl erfaßt. Strahler 5 und Empfänger 7 sind mit einem gewissen Abstand auf einem Träger oder Substrat angeordnet, um sicherzustellen, daß der Empfänger 7 nicht aufgrund seitlicher Abstrahlung des Lichtstrahls eine Fehlmessung durchführt. Dieser Reflexlichttaster weist ferner ein Gehäuse 6 auf, das schematisch durch ein Teil der Gehäusewand dargestellt ist. Die Gehäusewand des Gehäuses 6 bildet eine Betätigungsfläche, um durch Berühren dieser Betätigungsfläche mit einem Gegenstand, beispielsweise einem Finger, den Lichtstrahl des Strahlers 5 auf den Empfänger 7 zu reflektieren und so den zugehörigen Schalter zu betätigen. Klar ist, daß in jedem Fall nur ein Bruchteil der vom Strahler 5 emittierten Strahlung auf den Empfänger 7 zurückreflektiert wird.

Ein Nachteil des Standes der Technik ist, daß der Sensoraufbau nach wie vor einen relativ großen Platzbedarf hat, weil sowohl zwischen dem Empfänger 7 und der Berührungsfläche 6 als auch zwischen dem Strahler 5 und dem Empfänger 7 ausreichend Abstand gehalten werden muß, um ein sicheres Ausgangssignal erzielen zu können. Damit sind aber auch der Integration von Strahler und Empfänger in einem Gehäuse oder auf einem Chip deutliche Grenzen gesetzt, was wiederum einer weiteren Kostensenkung des Fertigungs- und Montageaufwandes entgegensteht. Eine weitere Möglichkeit besteht darin, zwischen Strahler 5 und Empfänger 7 eine lichtundurchlässige Abtrennung einzufügen, um eine direkte Einstrahlung des Strahlers 5 auf den Empfänger 7 auszuschließen. Dies verursacht jedoch ebenfalls einen nicht zu vernachlässigenden konstruktiven und fertigungstechnischen Aufwand und steht einer miniaturisierten und preiswerten Realisierung derartiger Systeme entgegen.

EP 0 243 411 beschreibt einen beleuchtbaren sensitiven Schalter, insbesondere eine berührungsempfindliche LED, die in einer der dargestellten Ausführungsformen eine lichtempfindliche Fotodiode und eine lichtsendende Diode innerhalb ein und desselben Gehäuses auf einem Substrat aufweist. Licht von der lichtsendenden Diode wird bei Annäherung eines Gegenstands auf die Fotodiode zurückreflektiert. Verschiedene Schaltzustände werden durch verschiedene Intensitäten oder Blinkfrequenzen der lichtsendenden Diode dargestellt.

Es besteht deshalb die Aufgabe, ein Leuchtmittel mit einem sensitiven Schalter zu schaffen, der bei Verwendung einer optoelektronischen Sensoranordnung als Betätigungsmittel einen kompakten Aufbau zuläßt und mit geringem Material- und Fertigungsaufwand hergestellt werden kann.

Diese Aufgabe wird durch ein Leuchtmittel mit den Merkmalen des Anspruches 1 gelöst. Vorteilhafte Weiterbildungen der Erfindung sind in den Unteransprüchen gegeben.

Demnach sieht die Erfindung ein Leuchtmittel mit mehreren LEDs und mit einem sensitiven Schalter vor, der eine optoelektronische Sensoranordnung , eine elektronische Steuereinheit und ein Schaltelement zum Schalten des Leuchtmittels enthält. Die optoelektronische Sensoranordnung selbst arbeitet nach dem Reflexlichttasterprinzip und weist einen Strahler in einem Lichtdurchlässigen Gehäuse, der einen Lichtmeßstrahl im sichtbaren Bereich aussendet, und ein fotosensitives Element auf, das im reflektierten Strahlengang des Strahlers, außerhalb des primären Strahlengangs des Lichtstrahls des Strahlers angeordnet ist und abhängig von dem reflektierten Licht-Meßstrahl ein Ausgangssignal erzeugt.

Die elektronische Steuereinheit wiederum steuert den Strahler an und betätigt abhängig von dem Ausgangssignal des fotosensitiven Elementes das Schaltelement und somit das Leuchtmittel. Erfindungsgemäß wird der Strahler durch eine der mehreren LEDs gebildet, wobei die elektronische Steuereinheit den Strahler zum Aussenden des Lichtmeßstrahls ansteuert, sowie den Strahler selbst sowie die weiteren LEDs auch als Leuchtmittel ansteuert.

Die Ansteuerung des Strahlers als Leuchtmittel läßt sich optimal bewerkstelligen, wenn der Strahler und das fotosensitive Element von der elektronischen Steuereinheit gemeinsam getaktet werden. Der gemeinsame Takt beinhaltet dabei einen Meß- und einen Arbeitszyklus. Im Meßzyklus gibt der Strahler mindestens einen Meßimpuls ab, während dessen das fotosensitive Element aktiviert ist, und im Arbeitszyklus wird bei optionaler Deaktivierung des fotosensitiven Elementes der Strahler von der elektronischen Steuereinheit als Beleuchtungsmittel angesteuert.

Der Takt umfaßt zumindest in regelmäßigen Intervallen einen Meßzyklus und einen Arbeitszyklus. In einer Ausführungsform der Erfindung kann der Takt während jeder Periode einen Meßzyklus und einen Arbeitszyklus umfassen. In einer anderen Ausführungsform ist es möglich, daß Meßzyklen nur in regelmäßigen Intervallen der Taktperiode auftreten. Während des Meßzyklusses kann das fotosensitive Element als Reflexionssignal-Detektor verwendet werden, währenddessen der Strahler mindestens einen Meßimpuls abgibt. Während des Arbeitszyklusses kann der Strahler von der elektronischen Steuereinheit als Leuchtmittel angesteuert werden.

Der Strahler ist in einem lichtdurchlässigen Gehäuse angeordnet. Dabei wirkt das lichtdurchlässige Gehäuse des Strahlers selbst als Lichtleiter und stellt gleichzeitig die Berührungs- oder Näherungsfläche dar, von der der von dem Strahler ausgesandte Lichtstrahl auf das fotosensitive Element reflektiert wird. Zur Realisierung der erfindungsgemäßen Sensoranordnung wird die Lichtleiterfunktion des lichtdurchlässigen Gehäuses des Strahlers ausgenutzt, und zwar nicht nur, um das Licht vom Strahler in Abstrahlrichtung nach vorne zu bündeln und auszukoppeln, sondern auch, um ggf. reflektiertes Licht bis zum Empfänger zurückzuleiten. Aufgrund der gezielten Ausnutzung der Lichtleiterfunktion des lichtdurchlässigen Gehäuses kann der Empfänger in unmittelbarer Nähe des Gehäuses angeordnet werden, wobei jedoch sinnvoll ist, daß er in Abstrahlrichtung hinter dem Sender angeordnet ist.

Der Strahler und das fotosensitive Element können beide innerhalb des lichtdurchlässigen Gehäuses angeordnet sein.

In einer bevorzugten Ausführungsform ist das fotosensitive Element (Empfänger) in Abstrahlrichtung des Strahlers hinter dem lichtdurchlässigen Gehäuse angeordnet. Das fotosensitive Element kann jedoch auch seitlich neben dem Gehäuse angeordnet werden, solange es in Abstrahlrichtung hinter dem Strahler liegt und eine Strahlauskopplung durch entsprechende Grenzflächen zwischen Medien unterschiedlicher optischer Dichte gegeben sind. Durch die Anordnung des fotosensitiven Elements außerhalb des Gehäuses des Strahlers ergibt sich eine besonders kostengünstige Ausführung der Sensoranordnung bei gleichzeitig geringem Platzbedarf. Außerhalb des lichtdurchlässigen Gehäuses reflektiertes Licht dringt dabei durch die lichtdurchlässige Fläche in das Gehäuse ein und wird ebenso wie an der lichtdurchlässigen Fläche reflektiertes Licht durch das Gehäuse hindurch bis zur Bodenplatte geleitet, wo es wieder austritt und wo das reflektierte Licht gezielt in den Empfänger außerhalb des Gehäuses eingekoppelt werden kann. Hierzu ist das fotosensitive Element im unmittelbaren Bereich des Gehäuses und außerhalb des Gehäuses, vorzugsweise in Abstrahlrichtung des Strahlers hinter dem Strahler angeordnet.

Des weiteren bietet sich an, das fotosensitive Element als Fotodiode oder als Fototransistor auszuführen.

Mit dem beschriebenen sensitiven Schalter ist es möglich, unter Verwendung eines Minimums an Bauteilen einen sehr kompakten Sensor aufzubauen, der keine optoelektronischen Spezialbauteile benötigt, sondern vollständig durch Standardbauteile, wie LEDs oder Fototransistoren, realisiert werden kann. Der Fertigungs- und Montageaufwand ist minimal.

Das Schaltelement kann prinzipiell als Ein-Aus-Schalter betrieben werden.

Es besteht aber auch die Möglichkeit, daß das Schaltelement durch die elektronische Steuereinheit so angesteuert wird, daß die Helligkeit des Leuchtmittels variiert werden kann. Dazu wird beispielsweise in Abhängigkeit von der Zeitdauer des Ausgangssignals des fotosensitiven Elementes das Schaltelement während des Arbeitszyklusses mit unterschiedlichen Tastverhältnissen angesteuert.

Der Strahler der optoelektronischen Sensoranordnung ist als LED in das Leuchtmittel integriert, welches eine Vielzahl von LEDs umfaßt, daher bietet sich dessen Anordnung im Zentrum oder an anderer exponierter Position des Leuchtmittels an. Dies läßt sich weiter hervorheben, indem beispielsweise die LED erhöht angeordnet und/oder in einer abweichenden Farbe gewählt wird.

Schließlich kann zum Schutz oder zu gestalterischen Maßnahmen das lichtdurchlässige Gehäuse des Strahlers und/oder das Leuchtmittel ganz oder teilweise mit einer lichtdurchlässigen Abdeckung versehen werden.

Als kostengünstig erweist sich prinzipiell, daß es sich beim dem Strahler um eine LED und wenn es sich bei dem fotosensitiven Element um eine Fotodiode oder um einen Fototransistor handelt. Die Empfindlichkeitsänderung des fotosensitiven Elementes wird dann durch die zeitweise Änderung eines Arbeitswiderstandes erzeugt. Aber auch kann die mindestens eine LED als Mehrfarben-LED gestaltet sein.

Der Strahler kann eine Lichtquelle sein, die sichtbares Licht in dem gesamten sichtbaren Lichtspektrum, d.h. im Bereich von 400 bis 800 Nanometer Wellenlänge oder auch darüber hinaus, aussendet. Vorzugsweise sendet der Strahler nicht nur monochromatische sondern breitbandigere sichtbare Strahlung wie beispielsweise weißes Licht aus.

Mit einer solchen Gestaltung des sensitiven Schalters zum Betätigen des Leuchtmittels ist es möglich, diesen bei Senkung des Material- und Herstellungsaufwandes sehr kompakt, hochintegriert und hochfunktional zu fertigen.

Die Erfindung schafft somit ein Leuchtmittel mit einem sensitiven Schalter , der mit geringem Aufwand an Material und Herstellungskosten gefertigt werden können. Bei Verwendung geeigneter Bauteile für die Sensoranordnung und das Leuchtmittel, wie LED im 3mm oder 5mm Gehäuse, Fotodioden und Fototransistoren beispielsweise im SMD-Gehäuse, wird eine hohe Zuverlässigkeit bei minimalem Energiebedarf erreicht. Zum Ein- und Ausschalten des Leuchtmittels muß der Schalter lediglich mit einem Gegenstand, wie einem Finger, berührt oder angenähert werden, um die Sensoranordnung zu aktivieren und somit den Schalter zu betätigen.

Die Erfindung ist im folgenden anhand bevorzugter Ausführungsformen mit Bezug auf die Zeichnungen näher erläutert. Es zeigen:
- Fig. 1: eine Ausführung der optoelektronischen Sensoranordnung;
- Fig.2: ein Blockschaltbild eines sensitiven Schalters für ein Leuchtmittel;
- Fig.3: den Signalverlauf bei Integration des Strahlers ins Leuchtmittel bei einer Helligkeitsregulierung auf ca. 50 %;
- Fig.4: den Signalverlauf bei Integration des Strahlers ins Leuchtmittel für drei unterschiedliche Helligkeitsstufen von 100 %, 50% u. ca. 5%;
- Fig. 5a: eine Draufsicht auf ein Leuchtmittel mit Integration des Strahlers im Zentrum;
- Fig.5b: eine Seitenansicht auf das Leuchtmittel nach Fig. 5a; und
- Fig.6: eine optoelektronische Sensoranordnung nach dem Stand der Technik

Die optoelektronische Sensoranordnung 3 ist der wesentliche Bestandteil des Leuchtmittels 2. Diese arbeitet nach dem Reflexlichttasterprinzip und besteht prinzipiell aus einem Strahler 5 mit einem lichtdurchlässigen Gehäuse 6 und aus einem fotosensitiven Element 7, das im reflektierten Strahlengang des Strahlers 5 angeordnet ist. Bezeichnend ist, daß das lichtdurchlässige Gehäuse 6 selbst und nicht wie üblich eine zusätzliche beabstandet angeordnete Betätigungsfläche als Berührungs- oder Näherungsfläche der optoelektronischen Sensoranordnung 3 ausgebildet ist, wobei das fotosensitive Element 7 im unmittelbaren Bereich des lichtdurchlässigen Gehäuses 6, das somit in dieser räumlichen Zuordnung als Lichtleiter wirkt, angeordnet ist.

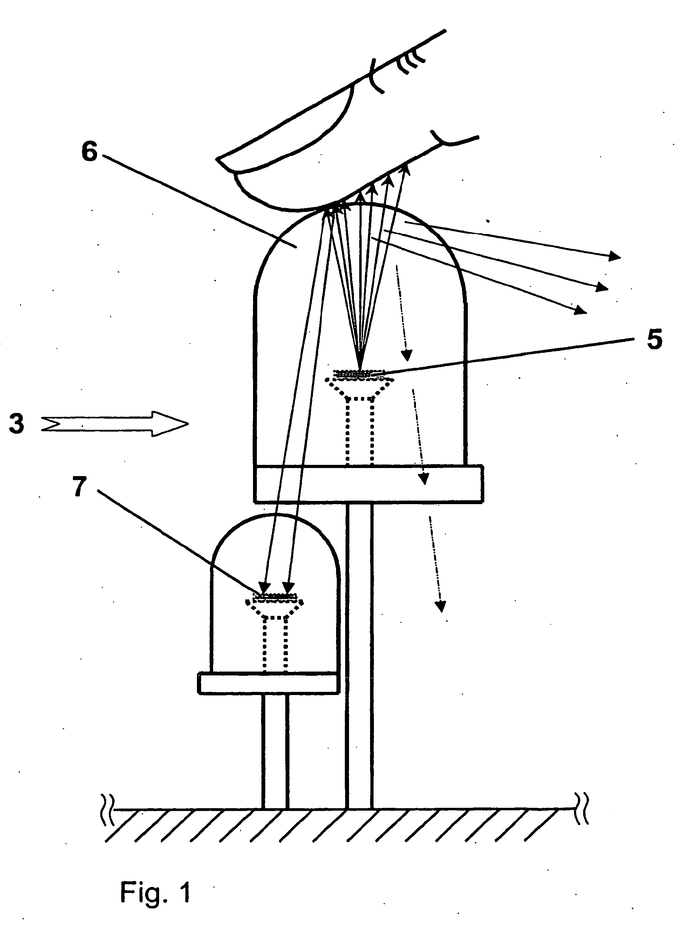

Eine Möglichkeit der Anordnung des fotosensitiven Elementes 7 besteht darin, dieses innerhalb des lichtdurchlässigen Gehäuses 6 des Strahlers 5 vorzusehen, z.B. sogar auf einem Substrat mit dem Strahler 5 zusammen. Mit der Fig. 1 ist eine weitere kostengünstige Gestaltung gegeben, denn hier ist das fotosensitive Element 7 unterhalb des lichtdurchlässigen Gehäuses 6 angeordnet. Wird nun das lichtdurchlässige Gehäuse 6 z. B. durch einen Finger berührt bzw. dieser in unmittelbare Nähe zum Gehäuse 6 gebracht, dann wird der gerichtete Strahlengang, ausgehend vom Strahler 5, vermehrt reflektiert und trifft auf das unterhalb des Gehäuses 6 angeordnete fotosensitive Element 7. Das lichtdurchlässige Gehäuse 6 bildet somit einen Lichtleiter. Die Folge ist, daß das fotosensitive Element 7 ein erhöhtes Ausgangssignal erzeugt, was eben die Berührung des Gehäuses 6 und damit die Betätigung der optoelektronischen Sensoranordnung 3 signalisiert.

Bei der Figur 1 ist der Strahler 5 eine LED und das fotosensitiven Element 7 ein Fototransistor. Dieser Fototransistor ist unterhalb der LED in unmittelbarer Nähe zum lichtdurchlässigen Gehäuse 6 angeordnet. Bei Berührung des Gehäuses 6 der LED wird der Strahlengang der LED an der Grenzfläche von Gehäuse 6 und Finger reflektiert und trifft, da das Gehäuse 6 als Lichtleiter wirkt, auf den Fototransistor. Dessen Ausgangssignal wird wiederum zum Schaltgerät zur Weiterverarbeitung weitergeleitet. Das Gehäuse 6 der LED wirkt als ein echter Lichtleiter, der das bei der Kuppel des Gehäuses 6 eintretende bzw. reflektierte Licht durch das Gehäuse 6 hindurch bis zur Bodenplatte leitet, wo es an den Grenzflächen nach unten und zur Seite hin abgegeben wird.

Eine besonders vorteilhafte Ausgestaltung der erfindungsgemäßen Anordnung ergibt sich dann, wenn das fotosensitive Element 7 als SMD-Bauelemente ausgeführt ist.

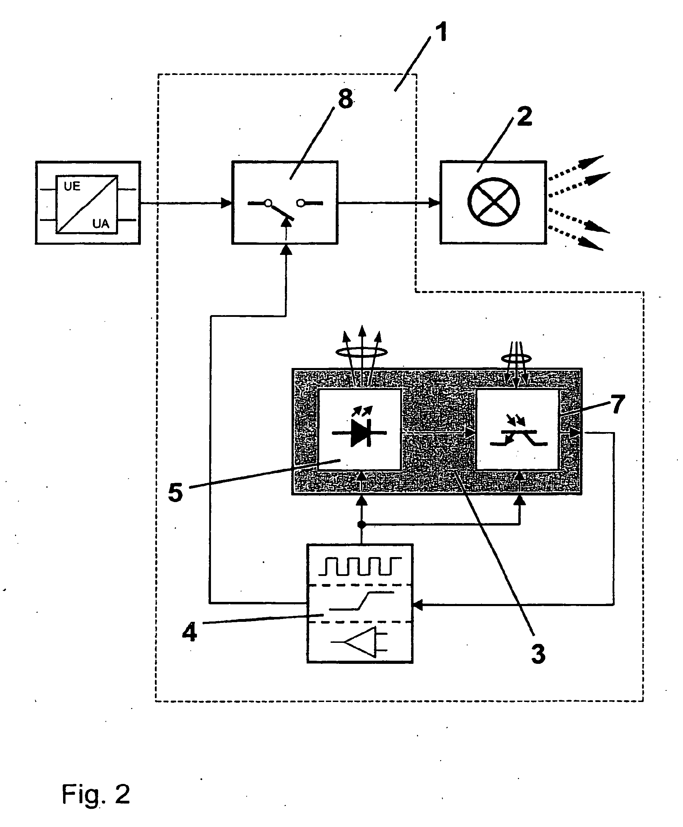

Eine solche, wie in Fig. 1 dargestellte, mögliche optoelektronische Sensoranordnung 3 findet Anwendung als Betätigungsmittel in dem sensitiven Schalter 1, dessen Funktionsweise nachfolgend an Hand des Blockschaltbildes gemäß Fig. 2 beschrieben wird. Dem Schalter 1 ist also als Betätigungsmittel eine optoelektronische Sensoranordnung 3 zugeordnet, wobei diese eben den Strahler 5 und das fotosensitive Element 7 enthält. Angesteuert wird die optoelektronische Sensoranordnung 3 wiederum von einer elektronischen Steuereinheit 4, wobei diese die optoelektronische Sensoranordnung 3 so beeinflußt, daß, wenn der Strahler 5 mindestens einen Licht-Meßstrahl aussendet, das fotosensitive Element 7 aktiviert ist und damit eine Messung des möglicherweise vermehrt reflektierten Licht-Meßstrahls möglich ist. Abhängig von dessen Ausgangssignal betätigt die elektronische Steuereinheit 4 das Schaltelement 8 des Schalters 1. Die Realisierung dieser Steuerung der optoelektronischen Sensoranordnung 3 besteht darin, daß sowohl der Strahler 5 als auch das fotosensitive Element 7 mit einem gemeinsamen Takt betrieben werden, wobei jeder Takt einen Meßzyklus und einen Arbeitszyklus beinhaltet. Während des Meßzyklusses gibt der Strahler 5 dann mindestens einen Impuls ab, während dessen das fotosensitive Element 7 aktiviert ist. Im Abhängigkeit vom Ausgangssignal des fotosensitiven Elementes 7 wird dann über die elektronische Steuereinheit 4 das Schaltelement 8 beeinflußt. Der Schalter 1 ist entweder "ON" oder "OFF" geschaltet, das Schaltelement 8 arbeitet also als Ein-Aus-Schalter.

Während des Meßzyklus gibt der Strahler 5 wenigstens einen Meßlichtstrahl aus, und das reflektierte Licht wird von dem fotosensitiven Element 7 in seiner Funktion als Reflexionssignal-Detektor erfaßt. Die elektronische Steuereinheit erkennt, anhand des durch das reflektierte Licht verursachten Pegels des Ausgangssignals des fotosensitiven Elements 7, ob ein Schaltvorgang zum Ein/Auschalten des Leuchtmittels ausgelöst werden soll. Wesentlich bei der Erfindung ist, daß ein und derselbe Strahler 5 in einem Zeit-Multiplexverfahren, durch Definieren eines Meßzyklus und eines Arbeitszyklus, einmal als Leuchtmittel und einmal als Sender der Sensoranordnung verwendet wird.

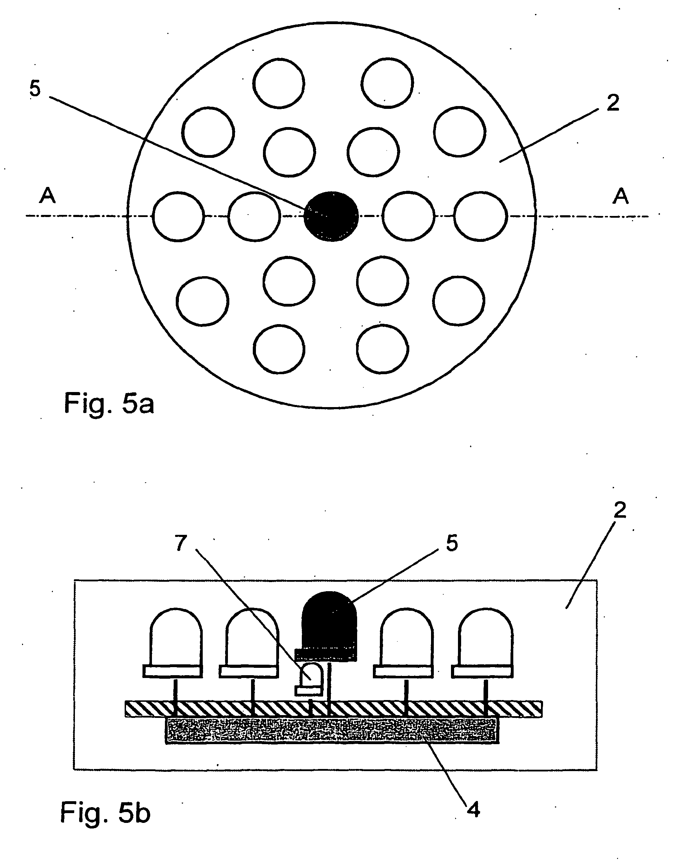

Da der sensitive Schalter 1 als Strahler 5 eine LED aufweist und in der Regel als fotosensitives Element 7 eine Fotodiode oder ein Fototransistor zur Anwendung kommt, kann dieser mit einer niedrigen Spannung betrieben werden. Zum Erhalt dieses deutlichen Vorteils ist daher die Bestückung des Leuchtmittels 2 ausschließlich mit LED's vorgesehen, so daß Schalter 1 und Leuchtmittel 2 direkt gekoppelt sind. Damit ist auch die eine LED des Strahlers 5 selbst mit in die LED-Struktur des Leuchtmittels 2 integriert, selbstverständlich einschließlich des fotosensitiven Elementes 7 und der elektronischen Steuereinheit 4, wie es die Fig. 5a und Fig. 5b zeigen. Die elektronische Steuereinheit 4 mit allen erforderlichen Funktionen kann besonders einfach und vorteilhaft durch einen Microcontroller realisiert werden. Damit muß nur noch die ausgewählte LED des Leuchtmittels 2, nämlich die, die als Strahler 5 dient, berührt werden, um das Leuchtmittel 2 mit dem Schalter 1 "ON" bzw. "OFF" zu schalten. Deren Anordnung im Zentrum des Leuchtmittels 2 ist eine günstige Plazierung des zu berührenden Strahlers 5. Zur weiteren Hervorhebung des Strahlers 5 in der LED-Struktur kann dieser auch erhöht angeordnet bzw. in einer abweichenden Farbe gewählt werden.

Um die Effizienz des Leuchtmittels weiter zu erhöhen, steuert die elektronische Steuereinheit 4 auch den Strahler 5 als Beleuchtungsmittel an. Dazu dient der Arbeitszyklus, indem bei optionaler Deaktivierung des fotosensitiven Elementes 7 der Strahler 5 in diesem Zeitabschnitt als Leuchtmittel aktiviert wird.

Weist der Strahler 5 mehrere LED's oder eine besonders strahlstarke LED auf, dann kann der Strahler 5 selbst als Leuchtmittel 2 ausgebildet sein.

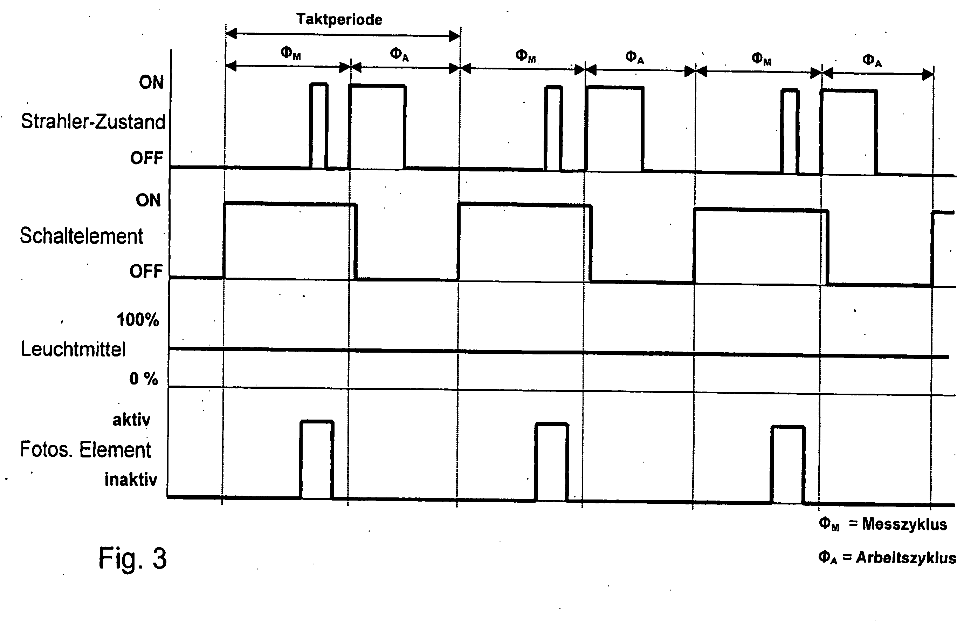

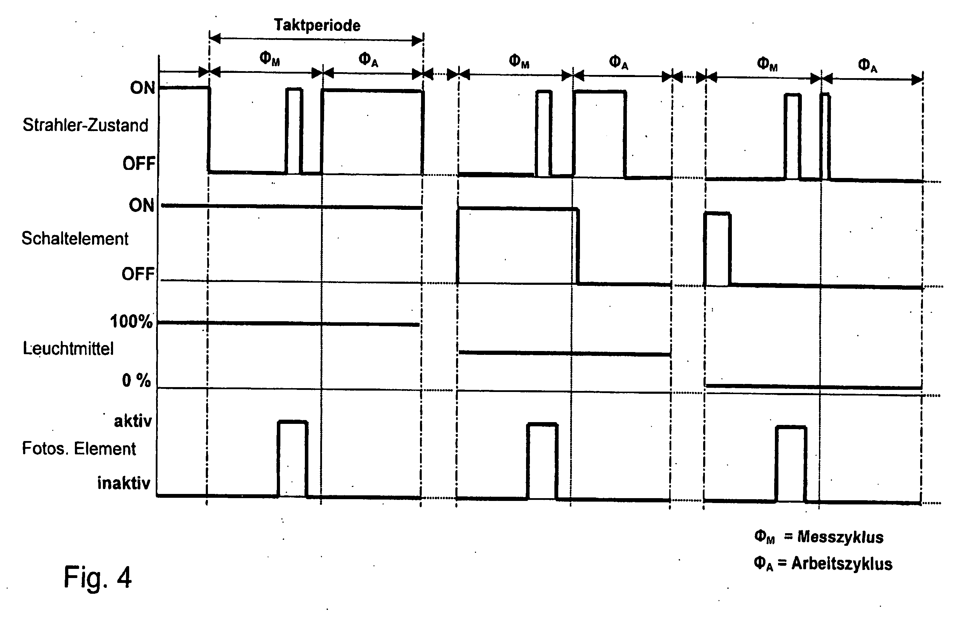

Aber auch läßt sich das Schaltelement 8 des sensitiven Schalters 1 so ansteuern, daß die Helligkeit des Leuchtmittels 2 variiert werden kann. Dazu steuert die elektronische Steuereinheit 4 in Abhängigkeit von der Zeitdauer des Ausgangssignals des fotosensitiven Elementes 7 das Schaltelement 8 mit unterschiedlichen Tastverhältnissen an. Aus den Fig. 3 und 4 sind die jeweiligen Signalverläufe von Strahler-Zustand, Schaltelement 8, Leuchtmittel 2 und fotosensitives Element 7 bei integriertem Strahler 5 in das Leuchtmittel 2, d.h. der Strahler 5 wird im Arbeitszyklus als Beleuchtungsmittel betrieben, zu entnehmen. In der Fig. 3 wird durch das Tastverhältnis am Schaltelement 8 eine Helligkeitsregelung auf ca. 50% eingestellt. Dagegen zeigt die Fig. 4, wie durch die Änderung des Tastverhältnisses die Helligkeit des Leuchtmittels 2 variiert werden kann. Beispielhaft sind die Helligkeitsstufen 100 %, 50% und ca. 5 % veranschaulicht.

Schließlich soll noch darauf hingewiesen werden, daß zum Schutz oder zu gestalterischen Maßnahmen das lichtdurchlässige Gehäuse 6 des Strahlers 5 und/oder das Leuchtmittel 2 ganz oder teilweise mit einer lichtdurchlässigen Abdeckung versehen werden können.

Die in der vorstehenden Beschreibung, den Ansprüchen und den Figuren offenbarten Merkmale können sowohl einzeln als auch in beliebiger Kombination für die Verwirklichung der Erfindung in ihren verschiedenen Ausgestaltungen von Bedeutung sein.

## Patentansprüche

1. Leuchtmittel mit mehreren LEDs und mit einem sensitiven Schalter (1), der eine optoelektronische Sensoranordnung (3), eine elektronische Steuereinheit (4) und ein Schaltelement (8) zum Schalten des Leuchtmittels enthält; wobei
die optoelektronische Sensoranordnung (3) nach dem Reflexlichttasterprinzip arbeitet und einen Strahler (5) in einem lichtdurchlässigen Gehäuse, der einen Lichtmeßstrahl im sichtbaren Bereich aussendet, ein fotosensitives Element (7), das im Bereich des reflektierten Strahlengangs des Strahlers (5) angeordnet ist und abhängig von dem reflektierten Licht-Meßstrahl ein Ausgangssignal erzeugt, und
eine Berührungs- oder Näherungsfläche aufweist, von welcher der von dem Strahler (5) ausgesandte Licht-Meßstrahl auf das fotosensitive Element (7) reflektiert wird; die elektronische Steuereinheit (4) den Strahler (5) ansteuert und das Schaltelement (8) abhängig von dem Ausgangssignal des fotosensitiven Elementes (7) steuert; eine der mehreren LEDs des Leuchtmittels (2) den Strahler (5) bildet; und
wobei die elektronische Steuereinheit (4) dazu eingerichtet ist, den Strahler (5) zum Aussenden des Lichtmeßstrahls anzusteuern sowie den Strahler (5) selbst und die weiteren LEDs auch als Leuchtmittel anzusteuern.

2. Leuchtmittel nach Anspruch 1, **dadurch gekennzeichnet, daß**
der Strahler (5) und das fotosensitive Element (7) von der elektronischen Steuereinheit (4) gemeinsam getaktet werden, wobei der Takt einen Meßzyklus zum Aussenden des LichtMeßstrahls und einen Arbeitszyklus zur Ansteuerung des Strahlers (5) als Leuchtmittel umfaßt.

3. Leuchtmittel nach Anspruch 2, **dadurch gekennzeichnet, daß** im Meßzyklus der Strahler (5) mindestens einen Meßimpuls abgibt, während dessen das fotosensitive Element (7) aktiviert ist.

4. Leuchtmittel nach einem der Ansprüche 1 bis 3, **dadurch gekennzeichnet, daß** der Strahler (5) und das fotosensitive Element (7) innerhalb eines lichtdurchlässigen Gehäuses (6) angeordnet sind, wobei das lichtdurchlässige Gehäuse (6) des Strahlers (3) als Lichtleiter wirkt und die Berührung- oder Näherungsfläche aufweist.

5. Leuchtmittel nach einem der Ansprüche 1 bis 3, **dadurch gekennzeichnet, daß** der Strahler (5) in einem lichtdurchlässigen Gehäuse (6) angeordnet ist, das als Lichtleiter wirkt und die Berührungs- oder Näherungsfläche aufweist, und das fotosensitive Element (7) in Abstrahlrichtung des Strahlers (5) hinter dem lichtdurchlässigen Gehäuse (6) angeordnet ist.

6. Leuchtmittel nach einem der vorangehenden Ansprüche, **dadurch gekennzeichnet, daß** das fotosensitive Element (7) als Fotodiode oder als Fototransistor ausgebildet ist.

7. Leuchtmittel nach einem der vorangehenden Ansprüche, **dadurch gekennzeichnet, daß** die elektronische Steuereinheit (4) das Schaltelement (8) als Ein-Aus-Schalter ansteuert.

8. Leuchtmittel nach einem der vorangehenden Ansprüche, **dadurch gekennzeichnet, daß** die elektronische Steuereinheit (4) das Schaltelement (8) so ansteuert, daß die Helligkeit des Leuchtmittels (2) variiert werden kann.

9. Leuchtmittel nach Anspruch 8, **dadurch gekennzeichnet, daß** zur Steuerung der Helligkeit des Leuchtmittels (2) die elektronische Steuereinheit (4) in Abhängigkeit von der Zeitdauer des Ausgangssignals des fotosensitiven Elementes (7) das Schaltelement (8) mit unterschiedlichem Tastverhältnis ansteuert.

10. Leuchtmittel nach einem der vorangehenden Ansprüche, **dadurch gekennzeichnet, daß** die den Strahler (5) bildende LED im Zentrum des Leuchtmittels (2) angeordnet ist.

11. Leuchtmittel nach einem der vorangehenden Ansprüche, **dadurch gekennzeichnet, daß** die den Strahler (5) bildende LED im Leuchtmittel (2) erhöht angeordnet ist.

12. Leuchtmittel nach einem der vorangehenden Ansprüche, **dadurch gekennzeichnet, daß** die den Strahler (5) bildende LED im Leuchtmittel (2) eine abweichende Farbe aufweist.

13. Leuchtmittel nach einem der vorangehenden Ansprüche, **dadurch gekennzeichnet, daß** zum Schutz oder zu gestalterischen Maßnahmen das lichtdurchlässige Gehäuse (6) des Strahlers (5) und/oder das Leuchtmittel (2) ganz oder teilweise mit einer lichtdurchlässigen Abdeckung versehen sind.

## Claims

1. Illuminating means comprising a plurality of LEDs and a sensitive switch (1) including an optoelectric sensor array (3), an electronic control unit (4) and a switch element (8) for switching said illuminating means; wherein
said optoelectric sensor array (3) operates according to the reflex light barrier principle and has an emitter (5) in a transparent housing, which emits a measurement light beam in the visible range, as well as a photosensitive element (7) arranged in the area of the reflected beam path of the emitter (5) and generating an output signal depending on the reflected measurement light beam, and
includes a touch or proximity surface from which the measurement light beam emitted by said emitter is reflected to said photosensitive element (7);
the electronic control unit (4) controls the emitter (5) and the switch element (8) depending on the output signal of the photosensitive element (7);
one of the plurality of LEDs of the illuminating means (2) forms the emitter (5); and
wherein the electronic control unit (4) is adapted to control the emitter (5) for emitting the measurement light beam as well as controlling the emitter (5) and the further LEDs as illuminating means.

2. Illuminating means according to claim 1, **characterized in that** the emitter (5) and the photosensitive element (7) are clocked together by the electronic control unit (4), wherein the clock comprises a measurement cycle for emitting the measurement light beam and an operating cycle for controlling the emitter (5) as illuminating means.

3. Illuminating means according to claim 2, **characterized in that** in the measurement cycle the emitter (5) emits at least one measurement pulse, while the photosensitive element (7) is activated.

4. Illuminating means according to one of claims 1 to 3, **characterized in that** the emitter (5) and the photosensitive element (7) are arranged in a transparent housing (6), wherein the transparent housing (6) of the emitter (3) forms a light guide and comprises said touch or proximity surface.

5. Illuminating means according to one of claims 1 to 3, **characterized in that** said emitter (5) is arranged in a transparent housing (6), forming a light guide and comprising said touch or proximity surface, and that the photosensitive element (7) is arranged behind the transparent housing (6) when seen in the direction of beam emission of the emitter (5).

6. Illuminating means according to one of the preceding claims, **characterized in that** the photosensitive element (7) is formed as photodiode or as phototransistor.

7. Illuminating means according to one of the preceding claims, **characterized in that** the electronic control unit (4) controls the switch element (8) as on-off switch.

8. Illuminating means according to one of the preceding claims, **characterized in that** the electronic control unit (4) controls the switch element (8) so that the brightness of the illuminating means (2) can be varied.

9. Illuminating means according to claim 8, **characterized in that** for controlling the brightness of the illuminating means (2) the electronic control unit (4) controls said switch element (8) with different duty cycles in dependence on the duration of the output signal of said photosensitive element (7).

10. Illuminating means according to one of the preceding claims, **characterized in that** the LED forming the emitter (5) is arranged in the center of said illuminating means (2).

11. Illuminating means according to one of the preceding claims, **characterized in that** the LED forming the emitter (5) is arranged in a raised manner in said illuminating means (2).

12. Illuminating means according to one of the preceding claims, **characterized in that** the LED forming the emitter (5) has a deviant color in said illuminating means (2).

13. Illuminating means according to one of the preceding claims, **characterized in that** for protection or as a design measure, said transparent housing (6) of said emitter (5) and/or said illuminating means (2) are completely or partly provided with a translucent cover.

## Revendications

1. Lampe avec plusieurs LED et avec un interrupteur sensitif qui contient un dispositif à capteur optoélectronique (3), une unité de commande électronique (4) et un élément de commutation (8) pour la commutation de la lampe ; où le dispositif à capteur optoélectronique (3) fonctionne suivant le principe d'un capteur de lumière réfléchie et comporte une source de rayonnement (5) dans un boîtier transparent, laquelle émet un faisceau lumineux de mesure dans la plage visible, un élément photosensible (7) disposé sur la trajectoire des rayons réfléchis de la source de rayonnement (5) et générant un signal de sortie en fonction du faisceau lumineux de mesure, et une surface de contact ou capacitive par laquelle le faisceau lumineux de mesure émis par la source de rayonnement (5) est réfléchi sur l'élément photosensible (7) ; où l'unité de commande électronique (4) excite la source de rayonnement (5) et commande l'élément de commutation (8) en fonction du signal de sortie de l'élément photosensible (7) ; où une des plusieurs LED de la lampe (2) forme la source de rayonnement (5) ; et où l'unité de commande électronique (4) est réalisée pour commander la source de rayonnement (5) à émettre le faisceau lumineux de mesure et à exciter la source de rayonnement (5) en tant que telle et les autres LED également en tant que lampes.

2. Lampe selon la revendication 1, **caractérisée**
**en ce que** la source de rayonnement (5) et l'élément photosensible (7) sont synchronisés par l'unité de commande électronique (4), la période comprenant un cycle de mesure pour l'émission du faisceau lumineux de mesure et un cycle de travail pour l'excitation de la source de rayonnement (5) en tant que lampe.

3. Lampe selon la revendication 2, **caractérisée en ce que** la source de rayonnement (5) délivre au moins une impulsion de mesure pendant le cycle de mesure, tandis que l'élément photosensible (7) est activé.

4. Lampe selon l'une des revendications 1 à 3, **caractérisée en ce que** la source de rayonnement (5) et l'élément photosensible (7) sont disposés à l'intérieur d'un boîtier transparent (6), ledit boîtier transparent (6) de la source de rayonnement (3) fonctionnant comme conducteur de lumière et comportant la surface de contact ou capacitive.

5. Lampe selon l'une des revendications 1 à 3, **caractérisée en ce que** la source de rayonnement (5) est disposée dans un boîtier transparent (6) fonctionnant comme conducteur de lumière et comportant la surface de contact ou capacitive, et **en ce que** l'élément photosensible (7) est disposé derrière le boîtier transparent (6) dans la direction de rayonnement de la source de rayonnement (5).

6. Lampe selon l'une des revendications précédentes, **caractérisée en ce que** l'élément photosensible (7) est réalisé comme photodiode ou comme phototransistor.

7. Lampe selon l'une des revendications précédentes, **caractérisée en ce que** l'unité de commande électronique (4) excite l'élément de commutation (8) en tant qu'interrupteur ON/OFF.

8. Lampe selon l'une des revendications précédentes, **caractérisée en ce que** l'unité de commande électronique (4) excite l'élément de commutation (8) de manière à pouvoir varier la luminosité de la lampe (2).

9. Lampe selon la revendication 8, **caractérisée en ce que** pour la commande de luminosité de la lampe (2), l'unité de commande électronique (4) excite l'élément de commutation (8) avec des facteurs de durée différenciés en fonction de la durée du signal de sortie de l'élément photosensible (7).

10. Lampe selon l'une des revendications précédentes, **caractérisée en ce que** la LED formant la source de rayonnement (5) est disposée au centre de la lampe (2).

11. Lampe selon l'une des revendications précédentes, **caractérisée en ce que** la LED formant la source de rayonnement (5) est disposée en hauteur dans la lampe (2).

12. Lampe selon l'une des revendications précédentes, **caractérisée en ce que** la LED formant la source de rayonnement (5) présente une couleur différente dans la lampe (2).

13. Lampe selon l'une des revendications précédentes, **caractérisée en ce que** pour la protection ou pour des raisons d'aspect, le boîtier transparent (6) de la source de rayonnement (5) et/ou la lampe (2) sont totalement ou partiellement pourvus d'un couvercle transparent.
